# EUROPEAN PATENT APPLICATION

(11) **EP 3 907 770 A1**
(43) Date of publication of application: **10.11.2021**
(21) Application number: 19921086.5
(22) Date of filing: 22.03.2019
(51) Int. Cl.: H01L 51/50, G02F 1/1335

(54) **ELECTRONIC DEVICE, DISPLAY APPARATUS AND PIXEL STRUCTURE**

(71) Applicant: GUANGDONG OPPO MOBILE TELECOMMUNICATIONS CORP., LTD., Dongguan, Guangdong 523860 (CN)
(72) Inventor: LI, Hua, Dongguan, Guangdong 523860 (CN); YANG, Xin, Dongguan, Guangdong 523860 (CN)
(74) Representative: Ipside
(86) International application number: PCT/CN2019/079357
(87) International publication number: WO 2020/191555

(57) **Abstract**

An electronic device, a display apparatus and a pixel structure. The electronic device comprises a display apparatus and a camera module, wherein the display apparatus comprises a plurality of organic light-emitting bodies, each of the organic light-emitting bodies has a quasi-circular structure; the camera module is arranged on a side, away from a display surface, of the display device, the display apparatus is multiplexed to be a lens of the camera module, and the camera module collects an optical signal by means of the display apparatus.

## Description

### TECHNICAL FIELD

The described embodiments relate to the field of electronic technology, and in particular to an electronic device, a display, and a pixel.

### BACKGROUND

With the development of communication technology, electronic devices such as smartphones are becoming more and more popular. When being used, the electronic device can display images through a display.

In related art, in order for a larger screen-to-body ratio, the top of the display defines an opening to accommodate a front camera, or the display is special-shaped and has a recess defined at the top in which the front camera is received. However, when displaying images, the display, whether defining the opening or the recess, is partially unable to display, thus affecting display effect.

### SUMMARY

The embodiments of the present disclosure provide an electronic device, a display, and a pixel, which can increase the screen-to-body ratio of the electronic device and improve the imaging quality of a camera of the electronic device.

An embodiment of the present disclosure provides an electronic device. The electronic device may include a display and a camera.

The display may include a plurality of organic light emitters. Each of the plurality of organic light emitters may be in a shape of circle-like.

The camera may be located at a side of the display away from a display face. The camera may be configured to acquire optical signals through the display.

An embodiment of the present disclosure provides an electronic device. The electronic device may include a display and a camera.

The camera may be located at a side of the display away from a display face. The display may further serve as a lens of the camera. The camera may be configured to acquire optical signals through the display.

An embodiment of the present disclosure provides a display. The display may include a pixel definition layer and an organic light-emitting layer.

The pixel definition layer may define a plurality of pixel holes.

The organic light-emitting layer may include a plurality of organic light emitters. Each of the plurality of organic light emitters may be received in one of the plurality of pixel holes. Each of the plurality of organic light emitters may be in a shape of circle-like.

An embodiment of the present disclosure provides a pixel. The pixel may include a pixel definition layer and an organic light-emitting layer.

The pixel definition layer may define a plurality of pixel holes.

The organic light-emitting layer may include a plurality of organic light emitters. Each of the plurality of organic light emitters may be received in one of the plurality of pixel holes. Each of the plurality of organic light emitters may be in a shape of circle-like.

### BRIEF DESCRIPTION OF THE DRAWINGS

In order to make the technical solution described in the embodiments of the present disclosure more clear, the drawings used for the description of the embodiments will be briefly described. Apparently, the drawings described below are only for illustration but not for limitation. It should be understood that, one skilled in the art might acquire other drawings based on these drawings, without paying any creative efforts.
FIG. 1 is a structural view of a first structure of an electronic device according to an embodiment of the present disclosure.
FIG. 2 is a structural view of a pixel of a display according to an embodiment of the present disclosure.
FIG. 3 is a partial structural view of a pixel of a display according to an embodiment of the present disclosure.
FIG. 4 is a structural view of a first structure of a display according to an embodiment of the present disclosure.
FIG. 5 is a structural view of a cooperation of a display and a camera of an electronic device according to an embodiment of the present disclosure.
FIG. 6 is a structural view of another cooperation of a display and a camera of an electronic device according to an embodiment of the present disclosure.
FIG. 7 is a structural view of a second structure of a display according to an embodiment of the present disclosure.
FIG. 8 is a structural view of a second structure of an electronic device according to an embodiment of the present disclosure.
FIG. 9 is a structural view of a pixel definition layer of an electronic device according to an embodiment of the present disclosure.
FIG. 10 is a structural view of a third structure of an electronic device according to an embodiment of the present disclosure.

### DETAILED DESCRIPTION

Technical solutions of the embodiments of the present disclosure may be clearly and comprehensively described by referring to accompanying figures of the embodiments. Obviously, embodiments to be described are only a part of, but not all of, the embodiments of the present disclosure. Any ordinary skilled person in the art may obtain other embodiments based on the embodiments of the present disclosure without any creative work, and the other embodiments should be included in the scope of the present disclosure.

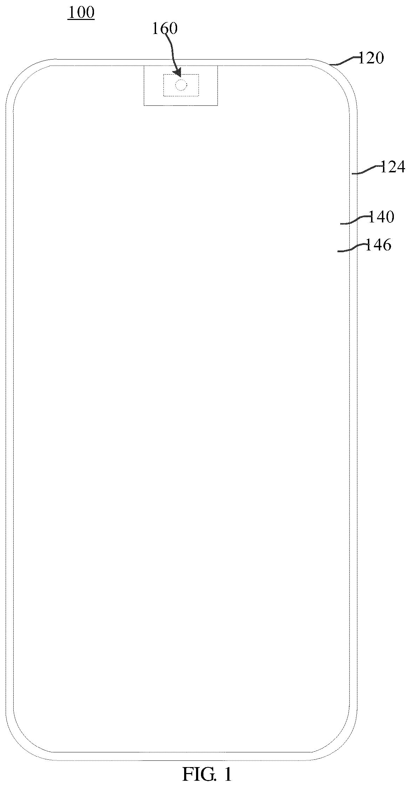

As illustrated in FIG. 1, the electronic device 100 may include a housing 120, a display 140, and a camera 160. The display 140 may be arranged on the housing 120. The housing 120 may include a rear cover (not shown) and a bezel 124. The bezel 124 may be arranged around a periphery of the rear cover. The display 140 may be disposed in the bezel 124. The display 140 and the rear cover may serve as two opposite sides of the electronic device 100. The camera 160 may be disposed between the rear cover of the housing 120 and the display 140. It is also understood that the display 140 may have a display face 146 and the camera 160 may be arranged at a side of the display 140 away from the display face 146. The camera 160 may be configured to acquire optical signals through the display 140 and generate images based on the acquired optical signals.

In some embodiments, the camera 160 may serve as a front camera of the electronic device 100. The camera 160 can capture images such as a selfie of a user through the display 140.

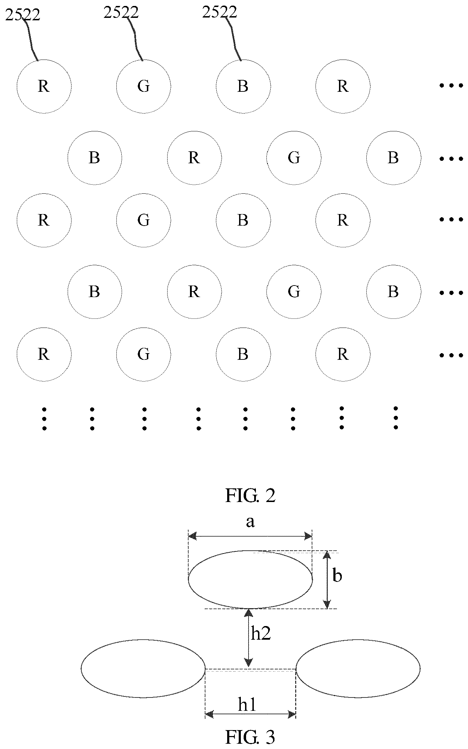

As illustrated in FIG. 2 in conjunction with FIG. 1, the display may include a plurality of organic light emitters 2522. Each of the plurality of organic light emitters 2522 may be in a shape of circle-like. The camera 160 may be arranged at a side of the display 140 away from the display face. The camera 160 may be configured to acquire the optical signals through the display 140.

Since each of the plurality of organic light emitters 2522 of the display 140 in related art is rectangular, when the optical signals pass through the plurality of organic light emitters 2522 in the shape of rectangle, the optical signals may produce diffraction phenomena due to the microstructure of the organic light emitters 2522. However, in the present embodiment, the plurality of organic light emitters 2522 may be circular-like, which can minimize diffraction effects. In this way, the camera can acquire optical signals of high quality, as well as generate high-quality images.

Furthermore, the plurality of organic light emitters 2522 may be arranged in a non-periodic arrangement. Since the plurality of organic light emitters 2522 of the display 140 in the related art have a periodic microstructure of pixels, when the optical signals pass through the plurality of organic light emitters 2522 arranged in a periodic arrangement, the optical signals may produce diffraction phenomenon due to the microstructure. In this embodiment, the plurality of organic light emitters 2522 may be circular-like and non-periodically arranged, which can minimize the diffraction effects. In this way, the camera 160 can acquire optical signals of high quality, as well as generate high-quality images.

In some embodiments, the plurality of organic light emitters 2522 may include organic light emitters 2522 with multiple colors, such as a plurality of red organic light emitters R, a plurality of green organic light emitters G, and a plurality of blue organic light emitters B. In order to synthesize color through the three colors of organic light emitters 2522, it is necessary to arrange the red organic light emitters R, green organic light emitters G, and blue organic light emitters B in groups, with each group including a red organic light emitter R, a green organic light emitter G, and a blue organic light emitter B. Organic light emitters 2522 with a same color may not be arranged adjacent to each other. In other words, organic light emitters 2522 adjacent to an organic light emitter 2522 of one color may be organic light emitters 2522 of the other two colors.

The plurality of organic light emitters 2522 being arranged in the non-periodic arrangement may mean that organic light emitters 2522 in two adjacent rows may not be aligned in columns, and organic light emitters 2522 in two adjacent columns may not be aligned in rows. The plurality of organic light emitters 2522 may be arranged in a plurality of rows. A projection of each organic light emitter 2522 in each row on an adjacent row may be located between two adjacent organic light emitters 2522 in the adjacent row. It may also be understood that the plurality of organic light emitters 2522 may be staggered in rows. For example, the plurality of organic light emitters 2522 may include an Nth row and an N+1st row of organic light emitters 2522. An Mth organic light emitter 2522 in the Nth row, and the M-1st and Mth organic light emitters 2522 in the N+1st row may be arranged in a " 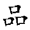 ", or the Mth organic light emitter 2522 in the Nth row, and the Mth organic light emitter 2522 and an M+1st organic light emitter 2522 in the N+1st row may be arranged in a " 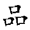 ". It is also understood that the Mth organic light emitter 2522 in the Nth row, and two organic light emitters 2522 adjacent to the Mth organic light emitter 2522 in the N+1st row may arranged in a " 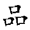 ". In particular, three organic light emitters 2522 arranged in a " 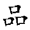 " may include a red organic light emitter R, a green organic light emitter G, and a blue organic light emitter B. In this way, colors of the three organic light emitters 2522 arranged in a " 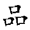 " can be mixed exactly according to the three primary colors, so as to produce the color to be displayed.

It should be noted that each organic light emitter 2522 may be in the shape of circle-like, such as any one of a hexagon, octagon, circle, oval, rounded rectangle, etc. In particular, any two adjacent sides of the hexagonal and octagonal may be transitively connected with each other through an arc. The configuration of the circular-like organic light emitters 2522 can effectively reduce the impact of diffraction on the photographing of the camera located under the display 140.

In some embodiments, a spacing between two adjacent organic light emitters 2522 may range from 10 microns to 30 microns. A distance from a center of each organic light emitter 2522 to an edge of the each organic light emitter 2522 may range from 25 microns to 45 microns.

If the plurality of organic light emitters 2522 are circular, the distance from a center of each organic light emitter 2522 to an edge of the each organic light emitter 2522 ranging from 25 microns to 45 microns can be understood that a radius of the each organic light emitter 2522 may range from 25 microns to 45 microns. If the plurality of organic light emitters 2522 have a shape of rounded rectangle, the distance from a center of each organic light emitter 2522 to the edge of the each organic light emitter 2522 ranging from 25 microns to 45 microns can be understood that a first distance from the center of the each organic light emitter 2522 to an edge of the each organic light emitter 2522 nearest to the center may range from 25 microns to 40 microns, and a second distance from the center of the each organic light emitter 2522 to an edge of the each organic light emitter 2522 farthest to the center may range from 35 microns to 45 microns. In particular, the first distance may be smaller than the second distance.

Each organic light emitter 2522 may have a first size in a first direction, and the each organic light emitter 2522 may have a second size in a second direction. Two adjacent organic light emitters 2522 arranged in the first direction may have a first spacing between each other, and two adjacent organic light emitters 2522 arranged in the second direction may have a second spacing between each other. In particular, the first size may be greater than the first spacing, and the second size may be greater than the second spacing. In this way, the diffraction effects generated by the optical signals passing through the plurality of organic light emitters 2522 can be weakened.

For example, with reference of FIG. 3, in which a group of three organic light emitters 2522 arranged in a " 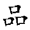 " is illustrated for ease of understanding. The arrangement of " 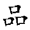 " may be a non-periodic configuration. When the three organic light emitters 2522 are elliptic, the first size a (along a long axis) may range from 70 microns to 90 microns, the first spacing h1 may range from 10 microns to 30 microns, the second size b (along a short axis) may range from 50 microns to 80 microns, and the second spacing h2 may range from 15 microns to 20 microns. Since organic light emitters 2522 in two adjacent rows are arranged in a staggered arrangement, a midpoint of the first spacing of two adjacent organic light emitters 2522 in one row and a bottom of a organic light emitters 2522 in an upper row may be the second spacing h2.

Another example is that when the organic light emitters 2522 are circular, a radius of the each organic light emitter 2522 may be 35 microns to 45 microns, a spacing between two adjacent organic light emitters 2522 in a row may be 10 microns to 30 microns, and a spacing between two adjacent organic light emitters 2522 in a column may be 10 microns to 30 microns. Specifically, the spacing between two organic light emitters 2522 adjacent in a row or in a column can be understood as a distance between two nearest points of the two organic light emitters 2522.

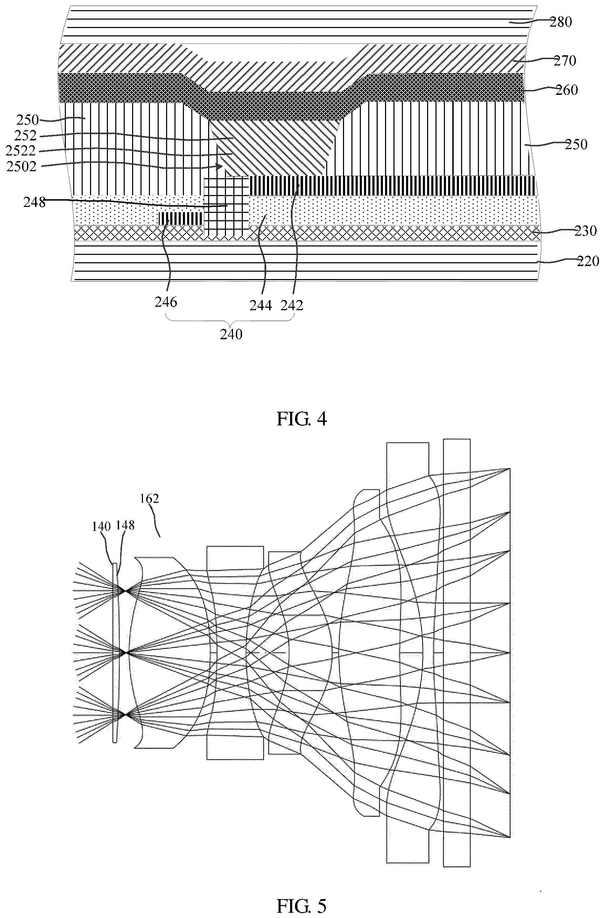

With reference of FIG. 4, in some embodiments, the display may include a pixel definition layer 250 and an organic light-emitting layer 252. The pixel definition layer 250 may define a plurality of pixel holes 2502. The organic light-emitting layer 252 may include the plurality of organic light emitters 2522. Each of the plurality of organic light emitters 2522 may be received in one of the plurality of pixel holes 2502. A shape of a pixel hole 2502 may match a shape of an organic light emitter 2522 received in the pixel hole 2502. For example, both the pixel hole 2502 and the organic light emitter 2522 received in the pixel hole 2502 may be circular-like. As an example, the pixel definition layer 250 may define a plurality of pixel holes 2502 with circular shapes, and then the plurality of pixel holes 2502 may be filled with organic light-emitting materials, thereby forming a plurality of organic light emitters 2522 shaped circles. In some other embodiments, the shape of the pixel hole 2502 may be different from the shape of the organic light emitter 2522 received in the pixel hole 2502. For example, the pixel hole 2502 has a square polygon shape, and the organic light emitter 2522 received in the pixel hole 2502 has a circular shape.

As shown in FIG. 5, a bottom face 148 of the display 140 closing to the camera may be a curved face. The display 140 may further serve as a lens (e.g., an encapsulated lens) of the camera 160. In an embodiment, the display 140 may further serve as an encapsulated lens of the camera 160, i.e., as an outermost lens of the camera 160 for transmitting the optical signals. The display may act as a lens (e.g., encapsulated lens) of a lens assembly 162 of the camera 160.

Specifically, in conjunction with FIG. 4, the display 140 may include a first substrate 220, an anode metal layer 240, the pixel definition layer 250, a common electrode layer 260, and a second substrate 280 arranged in a laminated manner. The pixel definition layer 250 and the organic light-emitting layer 252 may be disposed between the anode metal layer 240 and the common electrode layer 260. The anode metal layer 240 and the common electrode layer 260 may drive the organic light-emitting layer 252 in cooperation with each other, such that the organic light-emitting layer 252 can display various images.

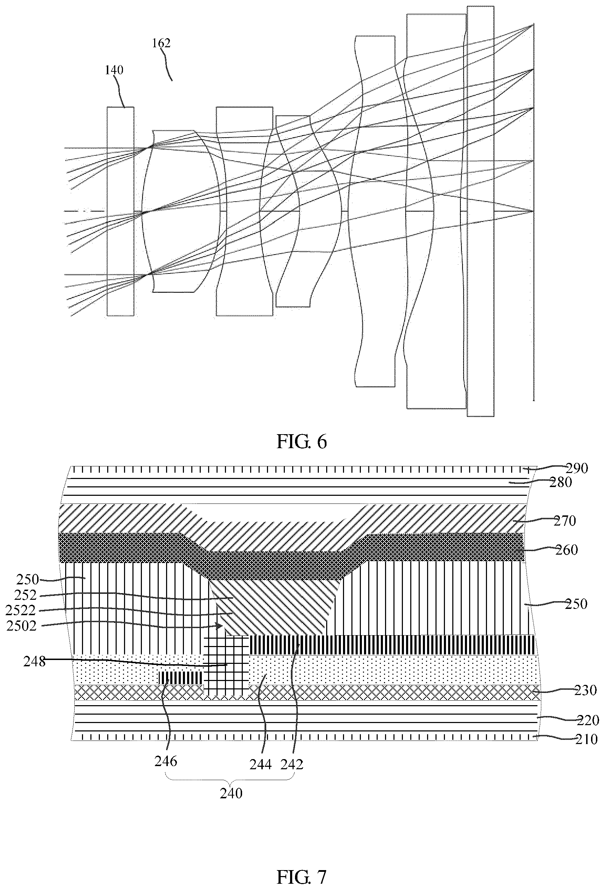

In particular, the bottom face 148 of the first substrate 220 closing to the camera 160 may be a curved face and projecting towards the camera 160. The first substrate 220 may further serve as a lens of the camera 160 such as an encapsulated lens. In this way, the optical signals passing through the first substrate 220 can be refracted to a greater extent. The bottom face 148 of the first substrate 220 closing to the camera 160 may be projecting towards the camera 160, and the first substrate 220 may serve as a lens of the lens assembly 162, thereby allowing for a large aperture and high quality imaging. A face of the first substrate 220 away from the camera 160 may be a plane. The bottom face of the display 140 towards the lens assembly 162 may be a curved face, and the light output may be distributed more freely according to design requirements, thus utilizing the light flux more efficiently and reducing unnecessary waste and dazzle. The display can be configured such that focus of the optical signals passing through the display may be in a same plane, in this way, the optical signals incident to other lenses may start from the same plane, similar to natural light incident directly to the other lenses. It can be understood that the bottom face of the display 140 towards the lens assembly 162 may be a curved face. With reference of FIG. 6, in other embodiments of the present disclosure, when both sides of the display 140 are flat, the focus of the optical signals passing through the display 140 may be distributed in different positions without being in a same plane. It can also be understood that optical path differences may be formed after the optical signals passing through different positions of the display 140, which may affect the imaging quality.

As illustrated in FIG. 7, in some embodiments, a one-way light-transmitting film 290 may be disposed on a surface of the second substrate 280 to prevent light incident into the camera from being reflected out by the display. Specifically, the one-way light-transmitting film 290 may be disposed on a side of the second substrate 280 facing towards the first substrate 220, or on a side of the second substrate 280 away from the first substrate 220. The one-way light-transmitting film 290 may allow a one-way transmission of the optical signals, such that the optical signals can only transmit through the second substrate 280 from one side of the second substrate 280 to another side of the second substrate 280. For example, the optical signals can only enter an inside of the display from an outside the display through the second substrate 280, and cannot be emitted from the inside of the display to the outside the display through the second substrate 280. The one-way light-transmitting film 290 can be formed on the surface of the second substrate 280 by coating, etc.

In order to hide the camera and truly realize the full-screen design, the second substrate 280 may also be performed with a one-way transmission optical treatment in addition to a transparent display 140. In other words, external optical signals can be incident into the camera penetrating through the display, but optical signals inside the camera may not be reflected out. In this way, when the display displays the image normally, light spots reflected from an optical surface of the lens assembly of the camera may be blocked by the one-way light-transmitting film 290 without affecting the actual display effect. When the camera works, the optical signals can be free to enter the inside of the camera passing through the transparent display for normal optical imaging, without affecting the photographing and picture recording effects.

In some embodiments, a refractive index of each light-transmitting layer of the display may be the same. Specifically, refractive indices of the first substrate 220, the anode metal layer 240, the organic light-emitting layer 252, the common electrode layer 260, and the second substrate 280 of the display may be substantially the same. It should be noted that since there are various materials available for each layer of the display 140, it is sufficient that the refractive indices of only some of the layers may be substantially the same as required, i.e., it is sufficient that refractive indices of at least two of the first substrate 220, the anode metal layer 240, the organic light-emitting layer 252, the common electrode layer 260, and the second substrate 280 of the display may be substantially the same. When the refractive indices are the same, the optical signals entering the display from different positions have approximately a same optical path, thereby reducing optical path differences and improving the imaging quality.

The display may be composed of multiple layers, and the material used for each layer may be different, accordingly, the refractive index of the material used for each layer may be different. When parallel light is incident in a functional area and passes through each layer, the light will be scattered due to different refractive indices of the material used for different layers, resulting in a blurred image obtained by the camera under the display 140. The use of materials with similar refractive indices for different layers can weaken the blurring phenomenon and improve the quality of the image obtained by the camera under the transparent display 140. An anti-reflection film 210 may further be arranged on the first substrate 220, in this way, the light transmittance of the display can be improved while the image clarity can be enhanced.

In some embodiments, the refractive index of each light-transmitting layer of the display may be the same. Since there are various materials available for each layer of the display 140, it is sufficient that the refractive indices of only some of the layers may be substantially the same as required, i.e., it is sufficient that refractive indices of at least two of the first substrate 220, the anti-reflection film 210, a thin film 230, a planarization layer 244, the pixel definition layer 250, the common electrode layer 260, a capping layer 270, the one-way light-transmitting film 290, and the second substrate 280 of the display may be substantially the same. In this way, the optical signals passing through the display may be more conducive to imaging.

The anode metal layer 240 may include a first anode metal layer 242, the planarization layer 244, and a second anode metal layer 246. The first anode metal layer 242 may be disposed between the planarization layer 244 and the pixel definition layer 250. The second anode metal layer 246 may be disposed between the planarization layer 244 and the first substrate 220. A refractive index of each light-transmitting layer of the display being substantially same may mean that refractive indices of the planarization layer and the other layers of the display 140 may be substantially same.

In particular, both the first substrate 220 and the second substrate 280 may be colorless and transparent substrates, and may be made of at least one of glass, resin, and other materials. The first substrate 220 and the second substrate 280 may be flexible substrates, and the display as a whole may be a flexible display.

The display 140 may further include a thin film transistor 248. The thin film transistor 248 may be connected to the first anode metal layer 242, the second anode metal layer 246, and the organic light-emitting layer 252. The first anode metal layer 242, the second anode metal layer 246, and the organic light-emitting layer 252 may be connected with different poles of the thin film transistor 248.

In some embodiments, an anti-reflection film 210 may be arranged on a surface of the first substrate 220. Specifically, the anti-reflection film 210 may be arranged on a side of the first substrate 220 facing towards the second substrate 280, or may be arranged on a side of the first substrate 220 away from the second substrate 280. The anti-reflection film 210 may be formed on the surface of the first substrate 220 by plating. The use of the anti-reflection film 210 may improve the light transmittance of the display.

In some embodiments, the display may further include a thin film 230. The thin film 230 may be disposed between the first substrate 220 and the anode metal layer 240. The film 230 may be made of SiNₓ or SiO₂.

In some embodiments, the display 140 may further include a capping layer (CPL) 270. The capping layer 270 may be disposed between the second substrate 280 and the common electrode layer 260.

It should be noted that the display 140 may or may not include at least one of the film 230 and the capping layer 270.

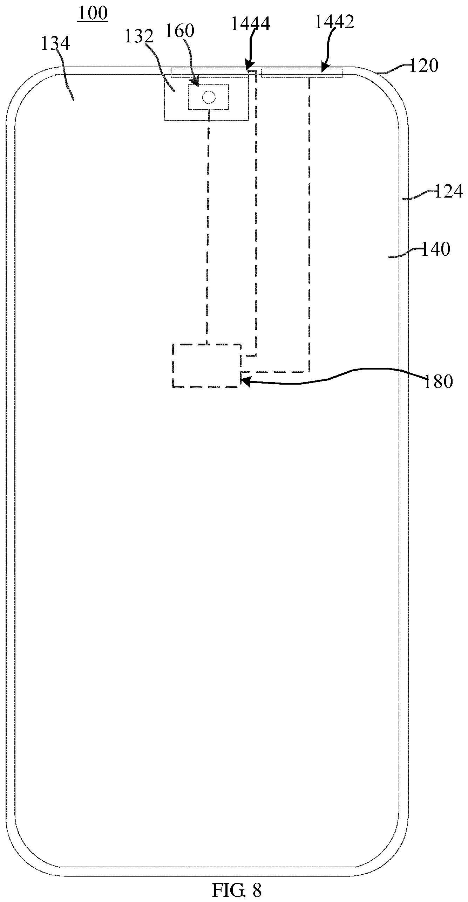

In some embodiments, as illustrated in FIG. 8, the display 140 may include a functional area 132 and a body area 134. An area of the functional area 132 may be smaller than an area of the body area 134. A light transmittance of the functional area 132 may be higher than a light transmittance of the body area 134. The camera 160 may be disposed facing towards the functional area 132. The camera 160 can acquire optical signals through the functional area 132. For example, the light transmittance of the functional area 132 may be greater than 60%. When the light transmittance of the functional area 132 is greater than 60%, an image enhancement algorithm can be used to enhance the brightness of the image acquired by the camera, thereby improving the quality of the under-display imaging to be closing to the quality of the imaging during which the optical signals are not passing through the display. It should be noted that the light transmittance of the functional area 132 being greater than 60% is just one example, and in some other embodiments, the light transmittance of the functional area 132 can be other values such as greater than 50%, 65%, 70%, etc. The bottom face of the display 140 closing to the lens assembly 162 being a curved face may mean that a whole of the bottom face may be a curved face or only a part of the bottom face 148 is a curved face. In consideration of a correspondence with the functional area 132, when only a part of the bottom face is a curved face, an area of the curved face of the bottom face 148 may be the same with the area of the functional area 132.

In particular, the functional area 132 may be connected with a first driver 1444, and the body area 134 may be connected with a second driver 1442. The first driver 1444 may be configured to drive the functional area 132 of the display 240. The second driver 1442 may be configured to drive the body area 134 of the display 240. The first driver 1442 and the second driver 1444 may cooperatively drive the display 140 such that the functional area 132 and the body area 134 can display a same image together. For example, the functional area 132 may display a part of an image, the body area 134 may display a remaining part of the image. When the camera 160 is to acquire an image, the first driver 1444 may drive the functional area 132 to be turned off, and the second driver 1442 may continue to drive the body area 134 to display or may drive the body area 134 to be turned off. The camera 160 can acquire the external optical signals through the functional area 132 turned off and generate images based on the acquired optical signals.

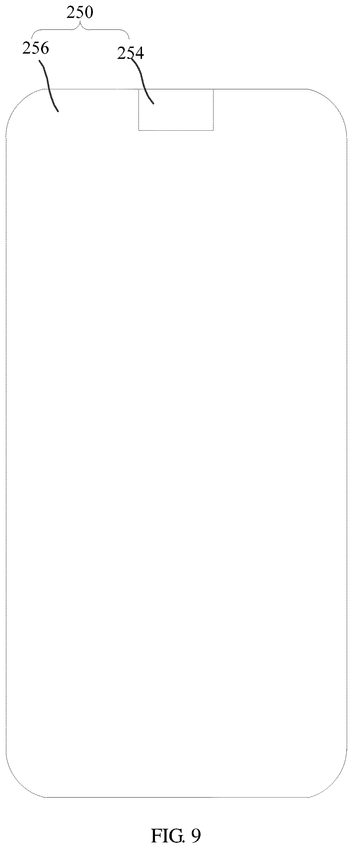

Referring to FIG. 9 in conjunction with FIGS. 7-8, in some embodiments, the pixel definition layer 250 may include a first portion 254 and a second portion 256. The first portion 254 may face towards the functional area, and the second portion 256 ma face towards the body area. An area of the first portion 254 may be smaller than an area of the second portion 256. A light transmittance of the first portion 254 may be greater than a light transmittance of the second portion. The camera 160 can acquire the optical signals through the first portion 254 of the display 140 and generate images based on the optical signals.

In some embodiments, the first portion 254 may be located at an end of the pixel definition layer 250. Specifically, the first portion 254 may be located at a top or bottom or side of the pixel definition layer 250. For example, when the pixel definition layer 250 is a rectangle, the second portion 256 may be a rectangle with a notch, the first portion 254 may be received in the notch, and the notch may be defined at a top or bottom or side edge of the second portion 256. The first portion 254 may also be disposed at the middle of the pixel definition layer 250, or it may be understood that the second portion 256 may have a through-hole running through the second portion 256 in a thickness direction of the pixel definition layer 250, and the first portion 254 may be received in the through-hole.

Correspondingly, the camera 160 may face towards the first portion The camera 160 can acquire the optical signals through the first portion 254 of the display 140. A light transmittance of a part of the display 140 where the first portion 254 is located may be greater than a light transmittance of a part of the display 12 where the second portion is located. Specifically, a distribution density of the organic light emitters 2522 located in the first portion 254 may be smaller. In other words, the distribution density of the organic light emitters 2522 located in the first portion 254 may be smaller than a distribution density of organic light emitters 2522 located in the second portion 256. Since the distribution density of the organic light emitters 2522 located in the first portion 254 is smaller, a distribution density of the thin film transistors 248 which are opaque and connected with the organic light emitters 2522 in a one-to-one correspondence may also be smaller, thereby increasing the light transmittance of the part of the display 140 where the first portion is located.

In some embodiments, a pixel density of the organic light emitters 2522 located in the first portion 254 may be smaller than a pixel density of the organic light emitters 2522 located in the second portion 256, which can also be understood that the distribution density of the organic light emitters 2522 located in the first portion 254 may be smaller than a distribution density of the organic light emitters 2522 located in the second portion 256. Specifically, a spacing between two adjacent pixel holes 2502 in the first portion 254 may be greater than a spacing between two adjacent pixel holes 2502 in the second portion 256. Since a light transmittance of the pixel definition layer 250 is greater than a light transmittance of the organic light emitter 2522, and the organic light-emitting layer 252 in the first portion 254 has a smaller proportion, the light transmittance of the first portion 254 is greater than the light transmittance of the second portion 256. In addition, each organic light emitter 2522 may face towards a thin film transistor 248 which may be opaque, and the organic light emitters 2522 located in the first portion 254 may have a smaller distribution density, accordingly the thin film transistor 248 may also have a smaller distribution density, such that the light transmittance of the first portion 254 is greater than the light transmittance of the second portion 256.

In some embodiments, the electronic device 100 may further include a processor 180. Both the display 140 and the camera 160 may be electrically connected to the processor 180. In response to a shooting instruction being received, the processor 180 may control the functional area 132 to be turned off and may control the camera 160 to capture images through the functional area 132. In response to a displaying instruction being received without a shooting instruction being received, the processor 180 may control the functional area 132 and the body area 134 to display images in cooperation with each other.

In some embodiments, the functional area 132 and the body area 134 may differ primarily in the pixel definition layer. The functional area 132 and the body area 134 may share a same first substrate 220, second substrate 280, etc.

It should be noted that a part of the anode metal layer 240 facing towards the first portion 254 may be made of a material with a high light transmittance, such as ITO, nano-silver, and the like. Another part of the anode metal layer 240 facing towards the second portion 256 may be made of a material with a high light transmittance, or a material with a low transmittance, or an opaque material.

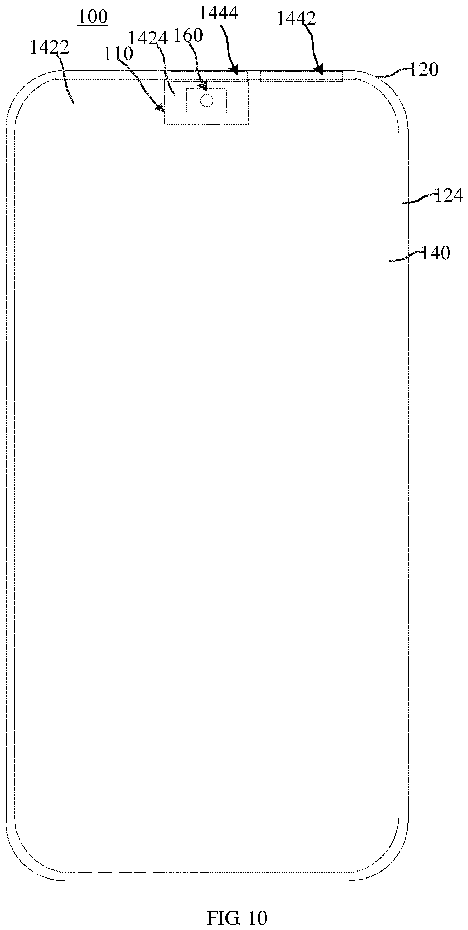

In some embodiments, as shown in FIG. 10, the display may include a first display panel 1422 and a second display panel 1424. The first display panel 1422 may define a gap 110. The gap 110 may penetrate through the first display panel 1422 in a thickness direction of the first display panel 1422. The first display panel 1422 may be configured to display normally. The second display panel 1424 may be received in the gap 110. The second display panel 1424 may face towards the functional area of the display 240, and the first display panel 1422 may face towards the body area of the display 240. The camera 160 of the electronic device 100 may be located between the housing and the second display panel 1424. The camera 160 can acquire the optical signals through the second display panel 1424 and generate images based on the acquired light signals.

The first display panel 1422 and the second display panel 1424 may be two display panels independent from each other. In the manufacturing process, the first display panel 1422 and the second display panel 1424 may be made separately, and then the second display panel 1424 may be placed in the gap 110 of the first display panel 1422.

It should be noted that, the first display panel 1422 may be connected with the second driver 1442, and the second display panel 1424 may be connected with the first driver 1444. The first driver 1444 may be configured to drive the second display panel 1424, and the second driver 1442 may be configured to drive the first display panel 1422. The first driver 1442 and the second driver 1444 may cooperatively drive the display 140 such that the first display panel 1422 and the second display panel 1424 may display a same image together. For example, the first display panel 1422 may display a part of an image, and the second display panel 1424 may display a remaining part of the image. When the camera 160 is to acquire an image, the first driver 1444 may drive the second display panel 1424 to be turned off, and the second driver 1442 may continue to drive the first display panel 1422 to display images. The camera can acquire external optical signals through the second display panel 1424 turned off and generate images based on the acquired optical signals.

The present disclosure may further provide an electronic device, with continued reference of FIGS. 1 and 5, the electronic device 100 may include a housing 120, a display 140, and a camera 160. The display 140 may be arranged on the housing 120. The housing 120 may include a rear cover (not shown) and a bezel 124. The bezel 124 may be arranged around a periphery of the rear cover. The display 140 may be disposed in the bezel 124. The display 140 and the rear cover may serve as two opposite sides of the electronic device 100. The camera 160 may be disposed between the rear cover of the housing 120 and the display 140. It is also understood that the display 140 may have a display face 146 and the camera 160 may be arranged at a side of the display 140 away from the display face 146. The camera 160 may be configured to acquire optical signals through the display 140 and generate images based on the acquired optical signals. In some embodiments, the camera 160 may serve as a front camera of the electronic device 100. The camera 160 can capture images such as a selfie of a user through the display 140.

The display 140 may further serve as a lens (e.g., an encapsulated lens) of the camera 160. The camera 160 may be configured to acquire optical signals through the display 140.

Specifically, a bottom face 148 of the display 140 closing to the camera module 160 may be a curved face. The display 140 may further serve as a lens (e.g., an encapsulated lens) of the camera 160. In an embodiment, the display 140 may further serve as an encapsulated lens of the camera 160, i.e., as an outermost lens of the camera 160 for transmitting the optical signals. The display 140 may act as a lens (e.g., encapsulated lens) of a lens assembly of the camera 160.

Specifically, the display 140 may include a first substrate 220, an anode metal layer 240, the pixel definition layer 250, a common electrode layer 260, and a second substrate 280 arranged in a laminated manner. The pixel definition layer 250 and the organic light-emitting layer 252 may be disposed between the anode metal layer 240 and the common electrode layer 260. The anode metal layer 240 and the common electrode layer 260 may drive the organic light-emitting layer 252 in cooperation with each other, such that the organic light-emitting layer 252 can display various images.

In particular, the bottom face 148 of the first substrate 220 closing to the camera 160 may be a curved face and projecting towards the camera 160. The first substrate 220 may further serve as a lens of the camera 160 such as an encapsulated lens. In an embodiment, the first substrate 220 may further serve as an encapsulated lens of the camera 160, i.e., as an outermost lens of the camera for transmitting the optical signals. In this way, the optical signals passing through the first substrate 220 can be refracted to a greater extent. The bottom face 148 of the first substrate 220 closing to the camera 160 may be projecting towards the camera 160, and the first substrate 220 may serve as a lens of the lens assembly 162, thereby allowing for a large aperture and high quality imaging. A face of the first substrate 220 away from the camera 160 may be a plane. A face of the display 140 towards the lens assembly 162 may be a curved face, and the light output may be distributed more freely according to design requirements, thus utilizing the light flux more efficiently and reducing unnecessary waste and dazzle. The display 140 can be configured such that focus of the optical signals passing through the display 140 may be in a same plane, in this way, the optical signals incident to other lenses may start from the same plane, similar to natural light incident directly to the other lenses. With reference of FIG. 6, in other embodiments of the present disclosure, when both sides of the display 140 are flat, the focus of the optical signals passing through the display 140 may be distributed in different positions without being in a same plane. It can also be understood that optical path differences may be formed after the optical signals passing through different positions of the display 140, which may affect the imaging quality. In particular, specific structure of the display 140 is the same as that of the display 140 of the electronic device in the above-mentioned embodiments and will not be repeated here.

The present disclosure may further provide a display. With reference of FIG. 4, in some embodiments, the display may include a pixel definition layer 250 and an organic light-emitting layer 252. The pixel definition layer 250 may define a plurality of pixel holes 2502. The organic light-emitting layer 252 may include a plurality of organic light emitters 2522. Each of the plurality of organic light emitters 2522 may be received in one of the plurality of pixel holes 2502. A shape of a pixel hole 2502 may match a shape of an organic light emitter 2522 received in the pixel hole 2502. For example, the organic light emitter 2522 may be circular-like. As an example, the pixel definition layer 250 may define a plurality of pixel holes 2502 with circular shapes, and then the plurality of pixel holes 2502 may be filled with organic light-emitting materials, thereby forming a plurality of organic light emitters 2522 shaped circles. In some other embodiments, the shape of the pixel hole 2502 may be different from the shape of the organic light emitter 2522 received in the pixel hole 2502. For example, the pixel hole 2502 has a square polygon shape, and the organic light emitter 2522 received in the pixel hole 2502 has a circular shape. In particular, the plurality of organic light emitters 2522 may be arranged in a non-periodic arrangement, and each organic light emitter 2522 may be in a shape of circle-like.

Since each of the plurality of organic light emitters 2522 of the display 140 in related art is an array, when the optical signals pass through the plurality of organic light emitters 2522 in the shape of rectangle, the optical signals may produce diffraction phenomena due to the microstructure of the organic light emitters 2522. However, in the present embodiment, the plurality of organic light emitters 2522 may be circular-like, which can minimize diffraction effects and improve the adverse diffraction effects produced by the optical signals passing through the display.

In particular, the plurality of organic light emitters 2522 may be arranged in a non-periodic arrangement. Since the plurality of organic light emitters 2522 of the display 140 in the related art have a periodic microstructure of pixels, when the optical signals pass through the plurality of organic light emitters 2522 arranged in a periodic arrangement, the optical signals may produce diffraction phenomenon due to the microstructure. In this embodiment, the plurality of organic light emitters 2522 may be circular-like and non-periodically arranged, which can minimize the diffraction effects. In this way, the camera 160 can acquire optical signals of high quality, as well as generate high-quality images.

In some embodiments, the plurality of organic light emitters 2522 may include organic light emitters 2522 with multiple colors, such as a plurality of red organic light emitters R, a plurality of green organic light emitters G, and a plurality of blue organic light emitters B. In order to synthesize color through the three colors of organic light emitters 2522, it is necessary to arrange the red organic light emitters R, green organic light emitters G, and blue organic light emitters B in groups, with each group including a red organic light emitter R, a green organic light emitter G, and a blue organic light emitter B. Organic light emitters 2522 with a same color may not be arranged adjacent to each other. In other words, organic light emitters 2522 adjacent to an organic light emitter 2522 of one color may be organic light emitters 2522 of the other two colors.

The plurality of organic light emitters 2522 being arranged in the non-periodic arrangement may mean that organic light emitters 2522 in two adjacent rows may not be aligned in columns, and organic light emitters 2522 in two adjacent columns may not be aligned in rows. The plurality of organic light emitters 2522 may be arranged in a plurality of rows. A projection of each organic light emitter 2522 in each row on an adjacent row may be located between two adjacent organic light emitters 2522 in the adjacent row. It may also be understood that the plurality of organic light emitters 2522 may be staggered in rows. For example, the plurality of organic light emitters 2522 may include an Nth row and an N+1st row of organic light emitters 2522. An Mth organic light emitter 2522 in the Nth row, and the M-1st and Mth organic light emitters 2522 in the N+1st row may be arranged in a " 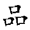 ", or the Mth organic light emitter 2522 in the Nth row, and the Mth organic light emitter 2522 and an M+1st organic light emitter 2522 in the N+1st row may be arranged in a " 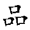 ". It is also understood that the Mth organic light emitter 2522 in the Nth row, and two organic light emitters 2522 adjacent to the Mth organic light emitter 2522 in the N+1st row may arranged in a " 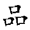 ". In particular, three organic light emitters 2522 arranged in a " 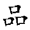 " may include a red organic light emitter R, a green organic light emitter G, and a blue organic light emitter B. In this way, colors of the three organic light emitters 2522 arranged in a " 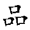 " can be mixed exactly according to the three primary colors, so as to produce the color to be displayed.

It should be noted that each organic light emitter 2522 may be in the shape of circle-like, such as any one of a hexagon, octagon, circle, oval, rounded rectangle, etc. In particular, any two adjacent sides of the hexagonal and octagonal may be transitively connected with each other through an arc. The configuration of the circular-like organic light emitters 2522 can effectively reduce the impact of diffraction on the photographing of the camera located under the display 140.

In some embodiments, a spacing between two adjacent organic light emitters 2522 may range from 10 microns to 30 microns. A distance from a center of each organic light emitter 2522 to an edge of the each organic light emitter 2522 may range from 25 microns to 45 microns. Structure, size and spacing related to the organic light emitters can be the same as the organic light emitters described in the above embodiment, and will not be repeated here.

The present disclosure may further provide a pixel. With continued reference of FIG. 2, the pixel may include a pixel definition layer 250 and an organic light-emitting layer 252. The pixel definition layer 250 may define a plurality of pixel holes 2502. The organic light-emitting layer 252 may include a plurality of organic light emitters 2522. Each of the plurality of organic light emitters 2522 may be received in one of the plurality of pixel holes 2502. A shape of a pixel hole 2502 may match a shape of an organic light emitter 2522 received in the pixel hole 2502. For example, both the pixel hole 2502 and the organic light emitter 2522 received in the pixel hole 2502 may be circular, elliptic, or rounded rectangular. As an example, the pixel definition layer 250 may define a plurality of pixel holes 2502 with circular shapes, and then the plurality of pixel holes 2502 may be filled with organic light-emitting materials, thereby forming a plurality of organic light emitters 2522.

In some other embodiments, the shape of the pixel hole 2502 may be different from the shape of the organic light emitter 2522 received in the pixel hole 2502. For example, the pixel hole 2502 has a square polygon shape, and the organic light emitter 2522 received in the pixel hole 2502 has a circular shape.

In particular, each organic light emitter 2522 may be in a shape of circle-like.

Since each of the plurality of organic light emitters 2522 of the display in related art is an array, when the optical signals pass through the plurality of organic light emitters 2522 in the shape of rectangle, the optical signals may produce diffraction phenomena due to the microstructure of the organic light emitters 2522. However, in the present embodiment, the plurality of organic light emitters 2522 may be circular-like, which can minimize diffraction effects. In this way, the camera can acquire optical signals of high quality, as well as generate high-quality images.

Furthermore, the plurality of organic light emitters 2522 may be arranged in a non-periodic arrangement. Since the plurality of organic light emitters 2522 of the display 140 in the related art has a periodic microstructure of pixels, when the optical signals pass through the plurality of organic light emitters 2522 arranged in a periodic arrangement, the optical signals may produce diffraction phenomenon due to the microstructure. In this embodiment, the plurality of organic light emitters 2522 may be circular-like and non-periodically arranged, which can minimize the diffraction effects. In this way, the camera 160 can acquire optical signals of high quality, as well as generate high-quality images.

In some embodiments, the plurality of organic light emitters 2522 may include organic light emitters 2522 with multiple colors, such as a plurality of red organic light emitters R, a plurality of green organic light emitters G, and a plurality of blue organic light emitters B. In order to synthesize color through the three colors of organic light emitters 2522, it is necessary to arrange the red organic light emitters R, green organic light emitters G, and blue organic light emitters B in groups, with each group including a red organic light emitter R, a green organic light emitter G, and a blue organic light emitter B. Organic light emitters 2522 with a same color may not be arranged adjacent to each other. In other words, organic light emitters 2522 adjacent to an organic light emitter 2522 of one color may be organic light emitters 2522 of the other two colors.

The plurality of organic light emitters 2522 being arranged in the non-periodic arrangement may mean that organic light emitters 2522 in two adjacent rows may not be aligned in columns, and organic light emitters 2522 in two adjacent columns may not be aligned in rows. The plurality of organic light emitters 2522 may be arranged in a plurality of rows. A projection of each organic light emitter 2522 in each row on an adjacent row may be located between two adjacent organic light emitters 2522 in the adjacent row. It may also be understood that the plurality of organic light emitters 2522 may be staggered in rows. For example, the plurality of organic light emitters 2522 may include an Nth row and an N+1st row of organic light emitters 2522. An Mth organic light emitter 2522 in the Nth row, and the M-1st and Mth organic light emitters 2522 in the N+1st row may be arranged in a " 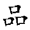 ", or the Mth organic light emitter 2522 in the Nth row, and the Mth organic light emitter 2522 and an M+1st organic light emitter 2522 in the N+1st row may be arranged in a " 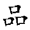 ". It is also understood that the Mth organic light emitter 2522 in the Nth row, and two organic light emitters 2522 adjacent to the Mth organic light emitter 2522 in the N+1st row may arranged in a " 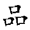 ". In particular, three organic light emitters 2522 arranged in a " 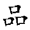 " may include a red organic light emitter R, a green organic light emitter G, and a blue organic light emitter B. In this way, colors of the three organic light emitters 2522 arranged in a " 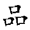 " can be mixed exactly according to the three primary colors, so as to produce the color to be displayed.

It should be noted that each organic light emitter 2522 may be in the shape of circle-like, such as any one of a hexagon, octagon, circle, oval, rounded rectangle, etc. In particular, any two adjacent sides of the hexagonal and octagonal may be transitively connected with each other through an arc. The configuration of the circular-like organic light emitters 2522 can effectively reduce the impact of diffraction on the photographing of the camera located under the display 140.

In some embodiments, a spacing between two adjacent organic light emitters 2522 may range from 10 microns to 30 microns. A distance from a center of each organic light emitter 2522 to an edge of the each organic light emitter 2522 may range from 25 microns to 45 microns.

If the plurality of organic light emitters 2522 are circular, the distance from a center of each organic light emitter 2522 to an edge of the each organic light emitter 2522 ranging from 25 microns to 45 microns can be understood that a radius of the each organic light emitter 2522 may range from 25 microns to 45 microns. If the plurality of organic light emitters 2522 have a shape of rounded rectangle, the distance from a center of each organic light emitter 2522 to the edge of the each organic light emitter 2522 ranging from 25 microns to 45 microns can be understood that a first distance from the center of the each organic light emitter 2522 to an edge of the each organic light emitter 2522 nearest to the center may range from 25 microns to 40 microns, and a second distance from the center of the each organic light emitter 2522 to an edge of the each organic light emitter 2522 farthest to the center may range from 35 microns to 45 microns. In particular, the first distance may be smaller than the second distance.

Each organic light emitter 2522 may have a first size in a first direction, and the each organic light emitter 2522 may have a second size in a second direction. Two adjacent organic light emitters 2522 arranged in the first direction may have a first spacing between each other, and two adjacent organic light emitters 2522 arranged in the second direction may have a second spacing between each other. In particular, the first size may be greater than the first spacing, and the second size may be greater than the second spacing. In this way, the diffraction effects generated by the optical signals passing through the plurality of organic light emitters 2522 can be weakened.

For example, with reference of FIG. 3, in which a group of three organic light emitters 2522 arranged in a " 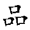 " is illustrated for ease of understanding. The arrangement of " 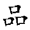 " may be a non-periodic configuration. When the three organic light emitters 2522 are elliptic, the first size a (along a long axis) may range from 70 microns to 90 microns, the first spacing h1 may range from 10 microns to 30 microns, the second size b (along a short axis) may range from 50 microns to 80 microns, and the second spacing h2 may range from 15 microns to 20 microns. Since organic light emitters 2522 in two adjacent rows are arranged in a staggered arrangement, a midpoint of the first spacing of two adjacent organic light emitters 2522 in one row and a bottom of a organic light emitters 2522 in an upper row may be the second spacing h2.

Another example is that when the organic light emitters 2522 are circular, a radius of the each organic light emitter 2522 may be 35 microns to 45 microns, a spacing between two adjacent organic light emitters 2522 in a row may be 10 microns to 30 microns, and a spacing between two adjacent organic light emitters 2522 in a column may be 10 microns to 30 microns. Specifically, the spacing between two organic light emitters 2522 adjacent in a row or in a column can be understood as a distance between two nearest points of the two organic light emitters 2522.

The electronic device, display and pixel provided in the embodiments of in the present disclosure have been described in detail above, and the principles and implementations of the present disclosure are described in the specific examples. The description of the above implementations is only used to help understand the method and core spirit of the present disclosure. In the meantime, one with ordinary skills in the art may obtain modifications on the specific embodiments and the application range according to the spirit of the present disclosure. In a word, the description shall not be considered as a limit to the present disclosure.

## Claims

1. An electronic device, comprising:
a display, comprising a plurality of organic light emitters, wherein each of the plurality of organic light emitters is in a shape of circle-like; and
a camera, located at a side of the display away from a display face and configured to acquire optical signals through the display.

2. The electronic device as claimed in claim 1, wherein a bottom face of the display closing to the camera module is a curved face, and the display further serves as a lens of the camera.

3. The electronic device as claimed in claim 1, wherein the display further comprises a first substrate, an anode metal layer, a common electrode layer, and a second substrate arranged in a laminated manner;
the plurality of organic light emitters are located between the anode metal layer and the common electrode layer, a face of the first substrate closing to the camera is a curved face and projecting towards the camera, and the first substrate further serves as a lens of the camera.

4. The electronic device as claimed in claim 3, wherein an anti-reflection film is disposed on a surface of the first substrate.

5. The electronic device as claimed in claim 3, wherein a one-way light-transmitting film is disposed on a surface of the second substrate and configured to prevent light incident into the camera from being reflected out by the display.

6. The electronic device as claimed in claim 3, wherein the first substrate, the anode metal layer, the plurality of organic light emitters, the common electrode layer, and the second substrate have a same refractive index.

7. The electronic device as claimed in any one of claims 1-6, wherein the plurality of organic light emitters are arranged in a non-periodic arrangement, a spacing between two adjacent organic light emitters of the plurality of organic light emitters ranges from 10 microns to 30 microns, and a distance from a center of each of the plurality of organic light emitters to an edge of the each of the plurality of organic light emitters ranges from 25 microns to 45 microns.

8. The electronic device as claimed in any one of claims 1-6, wherein the display comprises a functional area and a body area, a light transmittance of the functional area is greater than a light transmittance of the body area, and the camera is configured to acquire optical signals through the functional area.

9. The electronic device as claimed in any one of claims 1-6, further comprising a processor electrically connected with the display and the camera;
in response to a shooting instruction being received, the processor controls the functional area to be turned off and controls the camera to capture images through the functional area;
in response to a displaying instruction being received without a shooting instruction being received, the processor controls the functional area and the body area to display images in cooperation with each other.

10. An electronic device, comprising:
a display; and
a camera, located at a side of the display away from a display face;
wherein the display further serves as a lens of the camera, and the camera is configured to acquire optical signals through the display.

11. The electronic device as claimed in claim 10, wherein a bottom face of the display closing to the camera is a curved face.

12. The electronic device as claimed in claim 10, wherein the display comprises:
a pixel definition layer, defining a plurality of pixel holes;
an organic light-emitting layer, comprising a plurality of organic light emitters arranged in a non-periodic arrangement, wherein each of the plurality of organic light emitters is received in one of the plurality of pixel holes and in a shape of circle-like.

13. The electronic device as claimed in claim 12, wherein the plurality of organic light emitters are arranged in a non-periodic arrangement, a spacing between two adjacent organic light emitters of the plurality of organic light emitters ranges from 10 microns to 30 microns, and a distance from a center of each of the plurality of organic light emitters to an edge of the each of the plurality of organic light emitters ranges from 25 microns to 45 microns.

14. The electronic device as claimed in claim 12, wherein the display further comprises a first substrate, an anode metal layer, a common electrode layer, and a second substrate arranged in a laminated manner;
the pixel definition layer is disposed between the anode metal layer and the common electrode layer, a bottom face of the first substrate closing to the camera is a curved face and projecting towards the camera.

15. The electronic device as claimed in claim 14, wherein an anti-reflection film is disposed on a surface of the first substrate.

16. The electronic device as claimed in claim 14, wherein a one-way light-transmitting film is disposed on a surface of the second substrate and configured to prevent light incident into the camera from being reflected out by the display.

17. The electronic device as claimed in claim 14, wherein the first substrate, the anode metal layer, the pixel definition layer, the common electrode layer, and the second substrate have a same refractive index.

18. The electronic device as claimed in any one of claims 10-17, wherein the display comprises a functional area and a body area, a light transmittance of the functional area is greater than a light transmittance of the body area, and the camera is configured to acquire optical signals through the functional area.

19. The electronic device as claimed in any one of claims 10-17, further comprising a processor electrically connected with the display and the camera;
in response to a shooting instruction being received, the processor controls the functional area to be turned off and controls the camera module to capture images through the functional area;
in response to a displaying instruction being received without a shooting instruction being received, the processor controls the functional area and the body area to display images in cooperation with each other.

20. A display, comprising:
a pixel definition layer, defining a plurality of pixel holes; and
an organic light-emitting layer, comprising a plurality of organic light emitters, wherein each of the plurality of organic light emitters is received in one of the plurality of pixel holes and in a shape of circle-like.

21. The display as claimed in claim 20, wherein the plurality of organic light emitters are arranged in a non-periodic arrangement, a spacing between two adjacent organic light emitters of the plurality of organic light emitters ranges from 10 microns to 30 microns, and a distance from a center of each of the plurality of organic light emitters to an edge of the each of the plurality of organic light emitters ranges from 25 microns to 45 microns.

22. The display as claimed in claim 20, wherein the display comprises a functional area and a body area, a light transmittance of the functional area is greater than a light transmittance of the body area, and the plurality of organic light emitters arranged in a non-periodic arrangement are located in the functional area.

23. A pixel, comprising:
a pixel definition layer, defining a plurality of pixel holes; and
an organic light-emitting layer, comprising a plurality of organic light emitters, wherein each of the plurality of organic light emitters is received in one of the plurality of pixel holes and in a shape of circle-like.

24. The pixel as claimed in claim 23, wherein the plurality of organic light emitters are arranged in a non-periodic arrangement, a spacing between two adjacent organic light emitters of the plurality of organic light emitters ranges from 10 microns to 30 microns, and a distance from a center of each of the plurality of organic light emitters to an edge of the each of the plurality of organic light emitters ranges from 25 microns to 45 microns.
